# FASCICULE DE BREVET EUROPEEN

(11) **EP 1 617 470 B1**
(45) Date de publication et mention de la délivrance du brevet: **03.09.2008**
(21) Numéro de dépôt: 05354026.6
(22) Date de dépôt: 04.07.2005
(51) Int. Cl.: H01L 21/84, H01L 21/78, H01L 21/762, H01L 21/86

(54) **Ancrage, par oxydation latérale, des motifs d'un film mince pour empêcher le phénomène de démouillage**
Verankerung von Dünnschichtmustern durch seitliche Oxidation zum Verhindern des Entfeuchtungseffekts
Anchoring of thin film patterns using lateral oxidation to prevent the dewetting effect

(30) Priorité: 12.07.2004 FR 0407751
(43) Date de publication de la demande: 18.01.2006
(73) Titulaire: COMMISSARIAT A L'ENERGIE ATOMIQUE, 75752 Paris (FR)
(72) Inventeur: Barbe, Jean-Charles, 38100 Grenoble (FR); Drevet, Béatrice, 38000 Grenoble (FR); Vinet, Maud, 38000 Grenoble (FR); Jahan, Carine, 38100 Grenoble (FR)
(74) Mandataire: Jouvray, Marie-Andrée

(56) Documents cités:
- EP-A- 0 334 268
- WO-A-20/04038802
- US-A- 4 753 896
- US-A- 5 518 949
- US-A1- 2003 141 548
- US-A1- 2004 026 746
- FUNG S K H ET AL: "IMPACT OF SCALING SILICON FILM THICKNESS AND CHANNEL WIDTH ON SOI MOSFET WITH REOXIDIZED MESA ISOLATION" IEEE TRANSACTIONS ON ELECTRON DEVICES, IEEE INC. NEW YORK, US, vol. 45, no. 5, mai 1998 (1998-05), pages 1105-1110, XP000752630 ISSN: 0018-9383

## Description

### Domaine technique de l'Invention

L'invention concerne un procédé d'ancrage de motifs formés dans un film mince.

### État de la technique

Dans de nombreux domaines de la microélectronique, les dispositifs issus des technologies conventionnelles sur silicium massif sont, de plus en plus, remplacés par des dispositifs sur substrat Silicium sur Isolant (SOI) ou sur substrat SOI sous contrainte, plus connu sous le nom anglo-saxon "strained SOI". Un substrat SOI est constitué d'un substrat en silicium sur lequel est disposé une couche isolante, par exemple en oxyde, recouverte d'un film mince en silicium et un substrat "strained SOI" est un substrat SOI sur lequel est disposé un film mince contraint ou déformé. De tels substrats SOI permettent une isolation totale des micro-composants destinés à être Intégrés, tels que les circuits CMOS, grâce à la présence de la couche enterrée d'isolant disposée sur le substrat en silicium. Ils assurent également une réduction des capacités parasites et des effets de canaux courts.

Cependant, avec des températures et des durées classiquement utilisées dans le domaine de la micro-électronique, lorsque des motifs sont créés dans un film mince en silicium ayant une épaisseur inférieure à 10nm, un phénomène de démouillage en phase solide des motifs a tendance à se produire à haute température. Ce phénomène est, généralement, observé lors de l'étape de recuit précédant une étape de croissance par épitaxie, l'étape de recuit étant, par exemple, réalisée à 950°C. Il peut être observé, plus généralement, lors de toute étape à haute température durant laquelle la surface supérieure du motif ainsi que ses parois latérales sont libres.

En effet, les motifs formés dans un film mince, en silicium et d'une très faible épaisseur (inférieure à 10nm), sont intrinsèquement instables et ils évoluent spontanément vers une forme d'équilibre atteinte par transport de matière, majoritairement par diffusion de surface et qui, dans des cas extrêmes, correspond à une population de cristaux disjoints les uns des autres. L'énergie du système formé par cette population de cristaux est, alors, plus faible que celle du motif initial. Cette forme d'équilibre est donc néfaste pour la suite des étapes de fabrication d'un micro-composant tel qu'un transistor MOS pour lequel les différentes zones du transistor à définir dans le motif mince, par exemple la source, le drain, le canal..., peuvent ne plus être connexes. Un tel phénomène de démouillage se retrouve également pour tout type de film mince structuré, de très faible épaisseur et en matériau semi-conducteur capable de former un oxyde stable lors d'une oxydation thermique, tel que, par exemple, un composé de silicium et de germanium (SiGe).

Ce phénomène étant induit par la température élevée des étapes de fabrication des micro-composants et notamment l'étape de recuit, certains ont tenté de réaliser le recuit à une température moins élevée. En effet, pour des épaisseurs de films minces de l'ordre de 5 nm et pour des durées et des atmosphères de recuits usuelles, le fait de réaliser le recuit à une température inférieure à 800°C rend les films minces peu sensibles au démouillage. Cependant, les étapes suivantes, par exemple l'étape de nettoyage qui nécessite une désorption d'espèces ou bien l'étape d'épitaxie, ne permettent pas d'utiliser une telle température de recuit puisque, pour obtenir une interface capable d'assurer une bonne qualité cristalline du matériau épitaxié, la température de recult ne peut pas être inférieure à 800°C.

### Objet de l'Invention

L'invention a pour but d'empêcher le phénomène de démouillage de motifs d'un film mince lors d'une étape ultérieure de traitement à haute température.

Selon l'invention, ce but est atteint par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

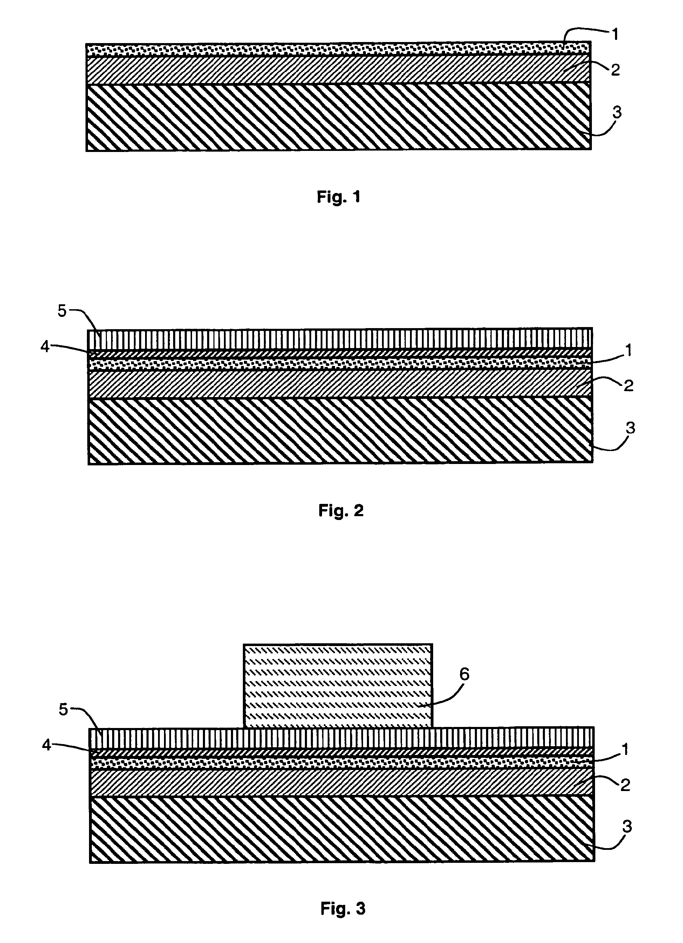

Les figures 1 à 6 représentent schématiquement, en coupe, différentes étapes d'un mode particulier de réalisation d'un film mince structuré, selon l'invention.

### Description de modes particuliers de réalisation

Comme représenté aux figures 1 à 6, un film mince 1 en matériau semi-conducteur oxydable, de préférence choisi parmi le silicium et un composé de silicium et de germanium est structuré sous forme de motifs 1a. Le film mince a une épaisseur inférieure à 10nm.

Ainsi, le film mince 1 est, de préférence, préalablement disposé sur la face supérieure d'une couche isolante 2 recouvrant un substrat 3 (figure 1). Dans l'exemple décrit, le substrat 3 est en silicium et la couche isolante 2 est en oxyde de silicium, généralement appelé oxyde enterré. L'ensemble constitué par le substrat et la couche isolante forme alors un substrat SOI.

Une couche d'oxyde 4, par exemple en oxyde de silicium ou constitué d'un bi-couche SiO₂/HfO₂, est, ensuite, formée sur la totalité de la surface libre du film mince 1 (figure 2). La couche d'oxyde 4 avec, de préférence, une épaisseur de l'ordre de 2nm peut être formée par dépôt chimique en phase vapeur à pression réduite, également appelé LPCVD, par dépôt chimique en phase vapeur assisté par plasma, également appelé PECVD ou bien par oxydation thermique d'une fine épaisseur du film mince 1. Puis, une couche de nitrure 5, par exemple de nitrure de silicium, est déposée sur la totalité de la surface libre de la couche d'oxyde 4. La couche de nitrure 5 a, de préférence, une épaisseur comprise entre 10nm et 20nm.

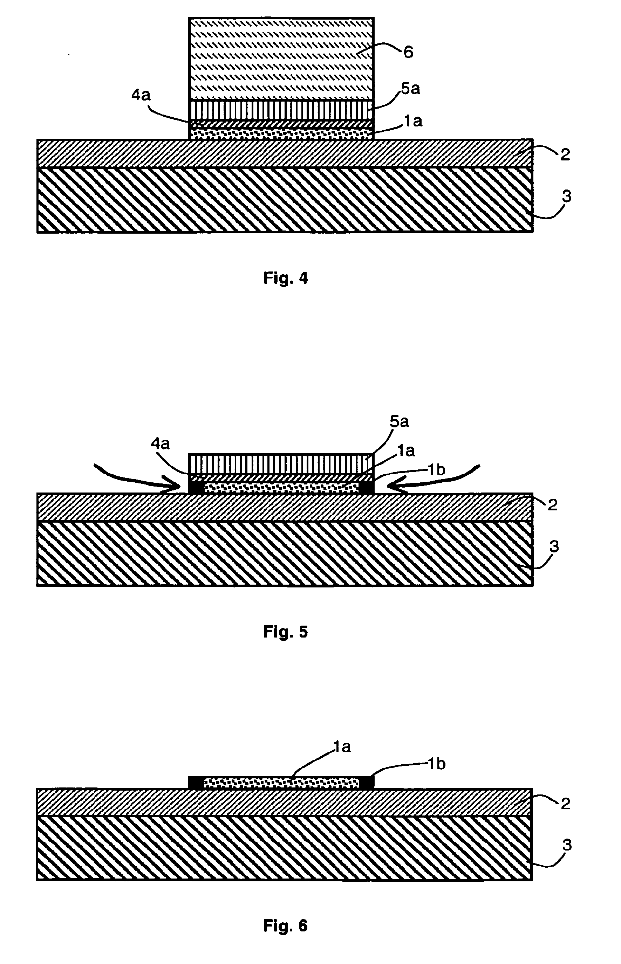

Les couches de nitrure et d'oxyde 5 et 4 et le film mince 1 sont ensuite structurés. La structuration peut, par exemple, s'arrêter à la surface de la couche isolante 2. Elle est, par exemple, réalisée par photolithographie ou par une méthode appelée "lithographie e-beam" et qui consiste à réaliser une lithographie par l'intermédiaire d'un masqueur électronique puis par gravure des couches de nitrure et d'oxyde et du film mince. Aux figures 3 et 4, les couches de nitrure et d'oxyde 5 et 4 et le film mince 1 sont structurés par photolithographie, au moyen d'un masque 6 en résine photosensible. Le masque 6 comporte des motifs et il est disposé à la surface libre de la couche de nitrure 5. Les couches de nitrure 5 et d'oxyde 4 et le film mince 1 sont ensuite gravés à travers le masque 6. Les zones des couches de nitrure 5 et d'oxyde 4 et du film mince 1 non recouvertes par les motifs du masque 6 sont ainsi éliminées de sorte que seules les zones recouvertes 5a, 4a et 1a respectivement de la couche de nitrure 5, de la couche d'oxyde 4 et du film mince 1 restent sur la face supérieure de la couche isolante 2 qui elle n'est pas structurée. Les zones 1a du film mince recouvertes par le masque 6 correspondent alors aux motifs du film mince.

Puis, comme illustré aux figures 5 et 6, le masque 6 est retiré, par exemple par combinaison d'un plasma oxygène et d'une solution chimique. Les zones 1a du film mince subissent alors une oxydation latérale de sorte que chaque motif du film mince comporte, à sa périphérie, une zone oxydée 1 b latérale de largeur prédéterminée. A la figure 5, l'oxydation latérale est illustrée par deux flèches disposées latéralement et de part et d'autre du motif 1a, de manière à former la zone oxydée 1 b à la périphérie du motif 1b. Puis, les couches de nitrure 5 et d'oxyde 4 sont retirées de manière à libérer le film mince structuré sous forme de motifs oxydés à leur périphérie. La couche de nitrure 5 est, par exemple, retirée par traitement chimique avec, par exemple, H₃PO₄ et si la couche d'oxyde 4 est en oxyde de silicium, elle peut, par exemple, être retirée au moyen d'une solution d'acide fluorhydrique.

Chaque motif du film mince en matériau semi-conducteur oxydable, muni, à sa périphérie, d'une zone oxydée latérale présente, ainsi, l'avantage d'être stable à des températures élevées et, donc d'être protégé contre le phénomène de démouillage susceptible de se produire lors d'une étape ultérieure de traitement à haute température telle qu'un recuit. En effet, le fait que chaque motif soit oxydé à sa périphérie, c'est-à-dire qu'il comporte une bordure périphérique oxydée, permet d'ancrer les motifs. Chaque bordure périphérique oxydée retarde, en effet, le phénomène de démouillage du motif correspondant car chaque bordure périphérique oxydée subit le phénomène de démouillage avant le reste du motif non oxydé et le démouillage d'une bordure périphérique oxydée passe par une déformation de la surface supérieure du motif préalablement plane, ce qui nécessite une augmentation de l'énergie du système. De plus, la surface de contact entre une bordure périphérique oxydée et la couche isolante constitue un point d'ancrage car elle correspond à une rugosité macroscopique qui doit être contournée pour que le motif puisse subir le phénomène de démouillage. De plus, la présence des couches d'oxyde et de nitrure 4 et 5, pendant l'étape d'oxydation latérale, permet d'empêcher l'oxydation de la surface du film mince 1. Elle permet, en outre, de contrôler indépendamment les épaisseurs de la couche d'oxyde 4 et des zones oxydées 1b. Ceci permet d'assurer qu'une fois les couches d'oxyde 4 et de nitrure 5 retirées, chaque motif soit toujours oxydé à sa périphérie.

Par ailleurs, l'oxydation latérale est, de préférence, réalisée par oxydation thermique. L'oxydation thermique est avantageusement réalisée dans des conditions de température et de pression partielle d'O₂ déterminées pour obtenir une vitesse d'oxydation thermique suffisamment lente pour contrôler la largeur de chaque zone oxydée créée.

La largeur de chaque zone oxydée est, de préférence, déterminée en fonction du mode de réalisation de l'oxyde utilisé pour la couche d'oxyde 4 car la vitesse de gravure d'un oxyde diffère selon le mode de réalisation utilisé. Plus particulièrement, la largeur des zones oxydées est déterminée par l'épaisseur de la couche d'oxyde 4 formée sur le film mince 1 et par le rapport entre les vitesses respectives de structuration de la couche d'oxyde 4 et des zones oxydées des motifs. Ainsi, un oxyde obtenu par oxydation thermique tel que celui des zones oxydées des motifs du film mince est gravé environ cinq fois moins vite qu'un oxyde obtenu par dépôt.

Selon le mode de réalisation utilisé pour former la couche d'oxyde 4, il est alors souhaitable de déterminer la largeur des zones à oxyder dans le film mince, de manière à ce qu'une fois libéré, le film mince 1 comporte encore des motifs oxydés à leur périphérie, c'est-à-dire que chaque motif comporte une bordure périphérique oxydée. Ainsi, si l'oxyde de la couche d'oxyde 4 est obtenu par oxydation thermique, l'oxydation latérale du film mince est, de préférence, réalisée pour que la largeur des zones oxydées du film soit, de préférence, supérieure à l'épaisseur de la couche d'oxyde 4 car la couche d'oxyde 4 et les zones oxydées du film mince ont des vitesses de gravure identiques. Si la couche d'oxyde 4 est déposée par dépôt LPCVD, la largeur de la zone oxydée peut être supérieure à 1/5^{ème} de l'épaisseur de la couche d'oxyde 4, ce rapport étant déterminé par le rapport des vitesses respectives de structuration de la couche d'oxyde 4 et de la zone oxydée. La largeur des zones oxydées est, par exemple, comprise entre 10 et 20 nm.

L'utilisation de couches en oxyde et en nitrure est connue en tant que telle pour réaliser des zones latérales oxydées. Par exemple, le brevet US5518949 décrit une méthode d'isolation électrique latérale pour des composants réalisés sur un substrat SOI. Cette méthode consiste à former latéralement un espacement en oxyde nécessitant la création par structuration, d'une marche dans la couche isolante, ce qui peut induire des difficultés technologiques lors des étapes ultérieures. Il est, en effet, nécessaire de supprimer cette marche par une combinaison d'étapes de planarisation des niveaux des contacts électriques. Une telle méthode nécessite également une gravure latérale de la couche de nitrure, ce qui rend le procédé sensible aux effets de charge qui peuvent alors induire des dispersions sur les caractéristiques électriques des dispositifs. De même, la demande de brevet WO-A-2004/038802 décrit, également, un procédé de fabrication d'un ensemble de transistors et de condensateurs. Ainsi, une couche mince, en matériau semi-conducteur et avec une épaisseur de 50nm, est formée sur un substrat SOI. Ladite couche mince est, ensuite, recouverte d'une couche d'oxyde de silicium et d'une couche de nitrure de silicium. Puis, les couches, respectivement de nitrure de silicium, d'oxyde de silicium et en matériau semi-conducteur, sont structurées, à l'aide d'un masque en résine photosensible et par gravure sèche. Une étape d'oxydation thermique est, ensuite réalisée, de manière à former sur les parois latérales de la couche mince en matériau semi-conducteur, des zones oxydées sensiblement arrondies. Les zones oxydées sont destinées à empêcher, ultérieurement, la formation de canaux parasites sur les flancs des motifs.

Ainsi, de manière connue, la formation d'une zone oxydée latérale autour d'un motif est utilisée pour isoler électriquement lesdits motifs tout au long du procédé de fabrication de micro-composants, tels que des transistors et des condensateurs. Par contre, l'objet de l'invention n'est pas d'isoler électriquement des motifs mais d'empêcher le phénomène de démouillage susceptible de se produire avec des motifs formés dans un film mince de très faible épaisseur (inférieure à 10nm). Ceci est obtenu par la création d'un ancrage autour du motif, réalisé par des bordures ou des zones périphériques oxydées. Le procédé de formation de cet ancrage permet également d'obtenir un film mince structuré sous forme de motifs, sans espaceur en oxyde. De plus, ledit procédé permet également d'utiliser une couche de nitrure de faible épaisseur, typiquement 10 nm, ce qui réduit le risque d'introduction potentielle de défauts par le nitrure.

Ainsi, selon l'invention, les motifs protégés contre le phénomène de démouillage, grâce à une zone oxydée périphérique, peuvent également être utilisés dans un micro-composant ne nécessitant pas d'isolation mesa. Ainsi, dans ce cas, les zones oxydées ne jouant pas de rôle électrique, elles peuvent être retirées dès que les étapes de traitement à haute température sont terminées.

L'invention n'est pas limitée aux modes de réalisation décrits ci-dessus. Ainsi, le film mince 1 n'est pas nécessairement disposé sur un substrat SOI, c'est-à-dire sur une couche isolante 2 recouvrant un substrat 3. Le film mince peut être disposé directement sur le substrat et, dans ce cas, l'étape de structuration des couches de nitrure et d'oxyde et du film mince s'arrête à la surface du substrat. Le substrat peut alors être un substrat massif, par exemple en silicium, ou bien il peut être composé d'un empilement de plusieurs couches d'un ou plusieurs matériaux. Le substrat peut également être, en surface, de même nature que le film mince qu'il supporte.

Par ailleurs, dans le mode de réalisation décrit aux figures 1 à 6, l'étape de structuration des couches de nitrure et d'oxyde et du film mince s'arrête à la surface de la couche isolante 2. La structuration pourrait également s'étendre légèrement dans la couche isolante 2 ou dans le substrat 3, si le film mince est disposé directement sur ledit substrat.

## Revendications

1. Procédé d'ancrage de motifs (1a) formés dans un film mince (1) visant à empêcher le phénomène de démouillage lors d'une étape ultérieure de traitement à haute température, **caractérisé en ce qu'**il consiste à utiliser des zones oxydées (1 b) latérales respectivement disposées à la périphérie de chacun des motifs (1a) formés dans un film mince (1), en matériau semi-conducteur oxydable et d'une épaisseur inférieure à 10nm, lesdites zones oxydées (1 b) provenant d'une oxydation latérale du film mince (1).

2. Procédé selon la revendication 1, **caractérisé en ce que** le matériau semi-conducteur du film mince (1) est choisi parmi le silicium et un composé de silicium et de germanium.

3. Procédé selon l'une des revendications 1 et 2, **caractérisé en ce que** le film mince (1) est disposé sur un substrat (3).

4. Procédé selon la revendication 3, **caractérisé en ce qu'**une couche isolante (2) est disposée entre le substrat (3) et le film mince (1).

5. Procédé selon l'une quelconque des revendications 1 à 4, **caractérisé en ce que** la largeur de la zone oxydée (1 b) du film mince (1) est comprise entre 10 et 20 nm.

6. Procédé selon l'une quelconque des revendications 1 à 5, **caractérisé en ce qu'**il comporte les étapes successives suivantes :
- formation d'une couche d'oxyde (4) sur l'ensemble du film mince, suivie du dépôt d'une couche de nitrure (5),
- structuration des couches de nitrure et d'oxyde (5, 4) et du film mince (1), ladite structuration s'arrêtant à la surface du substrat (3) ou à la surface d'une couche isolante (2) disposée entre ledit substrat (3) et le film mince (1) ou s'étendant légèrement dans le substrat ou dans ladite couche isolante (2),
- oxydation latérale du film mince (1) de sorte que chaque motif (1a) du film mince (1) comporte, à sa périphérie, une zone oxydée (1b) de largeur prédéterminée,
- retrait des couches de nitrure et d'oxyde (5, 4) de manière à libérer le film mince (1) structuré sous forme de motifs (1a) oxydés à leur périphérie.

7. Procédé selon la revendication 6, **caractérisé en ce que** l'épaisseur de la couche d'oxyde (4) est de l'ordre de 2nm.

8. Procédé selon l'une des revendications 6 et 7, **caractérisé en ce que** l'épaisseur de la couche de nitrure (5) est comprise entre 10nm et 20 nm.

9. Procédé selon l'une quelconque des revendications 6 à 8, **caractérisé en ce que** l'étape d'oxydation latérale est réalisée par oxydation thermique.

10. Procédé selon l'une quelconque des revendications 6 à 9, **caractérisé en ce que** la largeur de la zone oxydée (1 b) du film mince (1) est déterminée par l'épaisseur de la couche d'oxyde formée sur le film mince et par le rapport entre les vitesses respectives de structuration de la couche d'oxyde et de la zone oxydée.

11. Procédé selon la revendication 10, **caractérisé en ce que** la largeur de la zone oxydée (1 b) du film mince (1) est supérieure à l'épaisseur de la couche d'oxyde (4).

## Claims

1. Process for anchoring patterns (1a) formed in a thin film (1) aimed at preventing the dewetting phenomenon during a subsequent treatment step at high temperature, **characterized in that** it consists in the use of lateral oxidized zones (1b) respectively arranged at the periphery of each of the patterns (1a) formed in a thin film (1), made of oxidizable semi-conductor material and having a thickness of less than 10nm, said oxidized zones (1b) being achieved by lateral oxidation of the thin film (1).

2. Process according to claim 1, **characterized in that** the semi-conductor material of the thin film (1) is chosen from among silicon and a silicon and germanium compound.

3. Process according to one of claims 1 and 2, **characterized in that** the thin film (1) is arranged on a substrate (3).

4. Process according to claim 3, **characterized in that** an insulating layer (2) is arranged between the substrate (3) and the thin film (1).

5. Process according to any one of claims 1 to 4, **characterized in that** the width of the oxidized zone (1b) of the thin film (1) is comprised between 10 and 20nm.

6. Process according to any one of claims 1 to 5, **characterized in that** it comprises the following successive steps:
- formation of an oxide layer (4) over the whole of the thin film, followed by deposition of a nitride layer (5),
- patterning of the nitride and oxide layers (5, 4) and of the thin film (1), said patterning stopping at the surface of the substrate (3) or at the surface of an insulating layer (2) arranged between the said substrate (3) and the thin film (1) or extending slightly into the said substrate (3) or into the said insulating layer (2),
- lateral oxidizing of the thin film (1) so that each pattern (1a) of the thin film (1) comprises, at the periphery thereof, an oxidized zone (1b) of predetermined width,
- removal of the nitride and oxide layers (5, 4) so as to release the thin film (1) patterning in the form of patterns (1a) oxidized at their periphery.

7. Process according to claim 6, **characterized in that** the thickness of the oxide layer is about 2nm.

8. Process according to one of claims 6 and 7, **characterized in that** the thickness of the nitride layer (5) is comprised between 10nm and 20nm.

9. Process according to any one of claims 6 to 8, **characterized in that** the lateral oxidizing step is performed by thermal oxidizing.

10. Process according to any one of claims 6 to 9, **characterized in that** the width of the oxidized zone (1b) of the thin film (1) is determined by the thickness of the oxide layer formed on the thin film and by the ratio between the respective patterning rates of the oxide layer and of the oxidized zone.

11. Process according to claim 10, **characterized in that** the width of the oxidized zone (1b) of the thin film (1) is greater than the thickness of the oxide layer (4).

## Patentansprüche

1. Verfahren zum Verankern von in einer Dünnschicht (1) gebildeten Motiven (1a), das darauf abzielt, in einem späteren Behandlungsschritt bei hoher Temperatur dem Entnetzungsphänomen vorzubeugen, **dadurch gekennzeichnet, dass** es darin besteht, oxidierte seitliche Bereiche (1 b) zu verwenden, die jeweils am Rande jedes der Motive (1a) angeordnet sind, die in einer Dünnschicht (1) aus oxidierbaren Halbleitermaterial und mit einer Dicke von unter 10 nm gebildet sind, wobei die oxidierten Bereiche (1b) durch seitliche Oxidation der Dünnschicht (1) entstanden sind.

2. Verfahren nach Anspruch 1, **dadurch gekennzeichnet, dass** das Halbleitermaterial der Dünnschicht (1) aus Silizium bzw. einer Silizium-Germaniumverbindung ausgewählt ist.

3. Verfahren nach einem der Ansprüche 1 und 2, **dadurch gekennzeichnet, dass** die Dünnschicht (1) auf einem Substrat (3) angeordnet ist.

4. Verfahren nach Anspruch 3, **dadurch gekennzeichnet, dass** eine Isolierschicht (2) zwischen dem Substrat (3) und der Dünnschicht (1) vorgesehen ist.

5. Verfahren nach einem der Ansprüche 1 bis 4, **dadurch gekennzeichnet, dass** die Breite des oxidierten Bereichs (1 b) der Dünnschicht (1) 10 bis 20 nm beträgt.

6. Verfahren nach einem der Ansprüche 1 bis 5, **dadurch gekennzeichnet, dass** es die folgenden aufeinanderfolgenden Schritte umfasst:
- Bildung einer Oxidschicht (4) auf der ganzen Dünnschicht, anschließend Aufbringen einer Nitridschicht (5),
- Strukturierung der Nitrid- und Oxidschicht (5, 4) und der Dünnschicht (1), wobei die Strukturierung an der Oberfläche des Substrats (3) oder an der Oberfläche einer Isolierschicht (2) aufhört, die zwischen dem Substrat (3) und der Dünnschicht (1) angeordnet ist, oder sich leicht in das Substrat oder die Isolierschicht (2) hinein erstreckt,
- seitliche Oxidation der Dünnschicht (1) in der Weise, dass jedes Motiv (1a) der Dünnschicht (1) an seinem Rand einen oxidierten Bereich (1b) einer vorbestimmten Breite aufweist,
- Ablösen der Nitrid- und der Oxidschicht (5, 4), um die Dünnschicht (1) freizulegen, die in Form von Motiven (1 a) strukturiert ist, die an ihrem Rand oxidiert sind.

7. Verfahren nach Anspruch 6, **dadurch gekennzeichnet, dass** die Dicke der Oxidschicht (4) etwa 2 nm beträgt.

8. Verfahren nach einem der Ansprüche 6 und 7, **dadurch gekennzeichnet, dass** die Dicke der Nitridschicht (5) 10 bis 20 nm beträgt.

9. Verfahren nach einem der Ansprüche 6 bis 8, **dadurch gekennzeichnet, dass** der Schritt der seitlichen Oxidation mittels Thermooxidation erfolgt.

10. Verfahren nach einem der Ansprüche 6 bis 9, **dadurch gekennzeichnet, dass** die Breite des oxidierten Bereichs (1b) der Dünnschicht (1) von der Dicke der auf der Dünnschicht gebildeten Oxidschicht und von dem Verhältnis zwischen den jeweiligen Geschwindigkeiten der Strukturierung der Oxidschicht und des oxidierten Bereichs bestimmt wird.

11. Verfahren nach Anspruch 10, **dadurch gekennzeichnet, dass** die Breite des oxidierten Bereichs (1b) der Dünnschicht (1) über der Dicke der Oxidschicht (4) liegt.
